# EUROPEAN PATENT SPECIFICATION

(11) **EP 2 264 211 B1**
(45) Date of publication and mention of the grant of the patent: **15.02.2012**
(21) Application number: 10182013.2
(22) Date of filing: 08.07.2002
(51) Int. Cl.: C23C 14/08, C23C 14/34, H01L 31/18, H01B 5/14

(54) **Sputtering target**
Sputtertarget
Cible de pulverisation

(30) Priority: 02.08.2001 JP 2001235022; 27.09.2001 JP 2001296089; 27.09.2001 JP 2001297159
(43) Date of publication of application: 22.12.2010
(62) Divisional of application: 02741432.5
(73) Proprietor: Idemitsu Kosan Co., Ltd., Chiyoda-ku Tokyo 100-8321 (JP)
(72) Inventor: Inoue, Kazuyoshi, Sodegaura-shi, Chiba 299-0293 (JP); Matsuzaki, Shigeo, Sodegaura-shi, Chiba 299-0293 (JP)
(74) Representative: Gille Hrabal

(56) References cited:
- US-A- 6 042 752
- WEN S J ET AL: "Physical properties of sputtered germanium-doped indium tin oxide films (ITO:Ge) obtained at low deposition temperature" ACTIVE AND PASSIVE ELECTRONIC COMPONENTS, vol. 15, no. 2, 1993, pages 67-74, XP002608528 Hindawi Publishing Corporation [US] ISSN: 0882-7516 DOI: 10.1155/1993/13729
- CAMPET G ET AL: "The electronic effect of Ti4+, Zr4+ and Ge4+ dopings upon the physical properties of In2O3 and Sn-doped In2O3 ceramics: application to new highly-transparent conductive electrodes" MATERIALS SCIENCE & ENGINEERING B (SOLID-STATE MATERIALS FOR ADVANCED TECHNOLOGY), vol. B19, no. 3, 20 June 1993 (1993-06-20) , pages 285-289, XP002608529 Elsevier B.V. [NL] ISSN: 0921-5107 DOI: 10.1016/0921-5107(93)90200-7
- EDWARDS D D ET AL: "A new transparent conducting oxide film in the Ga2O3-In2O3-SnO2 system" APPLIED PHYSICS LETTERS, vol. 70, no. 13, 31 March 1997 (1997-03-31), pages 1706-1708, XP000689470 AIP, AMERICAN INSTITUTE OF PHYSICS, MELVILLE, NY [US] ISSN: 0003-6951 DOI: 10.1063/1.118676

## Description

### Technical Field

The present invention relates to a sputtering target making it possible to suppress the generation of nodules when a transparent conductive film is formed by sputtering, to attain the formation of the film stably.

### Background Art

Since liquid crystal display devices and electroluminescence display devices are excellent in displayer performance and consume small electric power, they are widely used in display instruments such as portable telephones, personal computers, word processors, and televisions. All of these display instruments have a sandwich structure wherein a display element is sandwiched between transparent conductive films. The main currents of the transparent conductive films used in these display instruments are indium tin oxide (abbreviated to ITO hereinafter) films. This is because the ITO films are excellent in transparency and electric conductivity, can be etched, and further are excellent in adhesiveness to substrates. The ITO films are usually formed by sputtering.

As described above, the ITO film has excellent performance as a transparent conductive film. However, when a target is used to form the film by sputtering, black precipitations (projections) called nodules are generated on the surface of the target. Accordingly, the speed of forming the film is lowered, or discharge voltage rises to cause abnormal discharge. At this time, there arises a problem that the nodules scatter and adhere to the substrate on which the film is formed, thereby causing the incorporation of alien substances into the transparent conductive film. When the nodules are generated, it is necessary to interrupt the operation for forming the film and remove the nodules on the target surface by polishing. For this reason, the productivity of the transparent conductive film is largely lowered.

Thus, in order to prevent alien substances from being incorporated into a transparent conductive film, following the scattering of nodules, without interrupting the operation for forming the transparent conductive film, it has been investigated to set up means for suppressing the generation of abnormal discharge in a power source circuit of a film-forming machine. However, the generation of the nodules has not yet been able to be completely suppressed. Furthermore, in order to suppress the generation of nodules, a target precursor is sintered at high temperature to make the density of the resultant high and decrease pores, thereby producing a target having a theoretical density ratio of about 99%. In this case, however, it is impossible to suppress the generation of nodules completely. Under such a situation, it has been desired to develop a target, for forming a transparent conductive film, making it possible to attain the formation of the film stably without generating any nodule at the time of the film-formation by sputtering.

Furthermore, an ITO film is etching-worked with a strong acid, aqua regia or the like when a circuit pattern is formed after the formation of the film. However, there is caused a problem that it is largely feared that aluminum, which is a wiring material for thin film transistors, is corroded. Thus, it has been desired to develop a transparent conductive film which can be etching-worked without producing any adverse effect on such a wiring material.

An object of the present invention is to provide a sputtering target making it possible to suppress the generation of nodules when a transparent conductive film is formed by sputtering and attain the formation of the film stably.

Sputtering targets of tin oxide containing gallium and indium are described in US 6,042,757 A.

Weng et al. (Active and Passive Elec. Comp. 1993; 15: 67-74) describe ways to improve the conductivity of ITO films by doping with germanium.

### Disclosure of the Invention

In order to solve the above-mentioned problems, the present inventors made eager investigation repeatedly. As a result, it has been found out that a nodule generated in a target for forming an ITO film is basically a digging-residue when the surface of the target is sputtered, and the cause that this digging-residue is generated depends on the crystal grain size of a metal oxide which constitutes the target. That is, it has been found out that when the crystal of indium oxide, which is a metal oxide which constitutes the target, gets large to exceed a given grain size, the generation of nodules on the surface of the target increases abruptly. When the target surface is struck off by sputtering, the speed that the target is struck off is varied dependently on the direction of the crystal plane. Thus, irregularities are generated in the target surface. The size of the irregularities depends on the size of crystal grains present in the sintered product. Accordingly, it is considered that in a target made of a sintered product having a large crystal grain size, irregularities thereof get large and nodules are generated from convex portions thereof. On the basis of such a finding, the present invention has been made.

That is, according to the present invention, the following sputtering targets can be obtained.
[1] A sputtering target, comprising a sintered product of a metal oxide comprising 85 to 99% by mass of [A1] (a1) indium oxide, and 1 to 15% by mass of the total of [B] gallium oxide and [C] germanium oxide, wherein the sintered product comprises, as components of the indium oxide, indium oxide wherein gallium atoms are solid-dissolved by substitution and indium oxide wherein germanium atoms are solid-dissolved by substitution.

Since these sputtering targets are each made of crystal having a small grain size, it is possible to suppress the generation of nodules generated in the surface of the target when a transparent conductive film is formed, and conduct sputtering stable.

### Best Modes for Carrying Out the Invention

Embodiments of the present invention are described hereinafter.

The sputtering target of the present invention is a sputtering target comprising a sintered product of a metal oxide comprising 85 to 99% by mass of [A1] (a1) indium oxide, and 1 to 15% by mass of the total of [B] gallium oxide and [C] germanium oxide, wherein the sintered product comprises, as components of the indium oxide, indium oxide wherein gallium atoms are solid-dissolved by substitution and indium oxide wherein germanium atoms are solid-dissolved by substitution.

The indium oxide wherein the gallium atoms are solid-dissolved into indium oxide component by substitution and the indium oxide wherein the germanium atoms are solid-dissolved into indium oxide component by substitution in this sintered product are oxides obtained as follows: when fine powder of indium oxide, gallium oxide and germanium oxide as starting materials are sintered, gallium atoms and germanium atoms are solid-dissolved into some parts of crystal of the indium oxide by substitution. When all of the gallium oxide and the germanium oxide which are used as the sintering starting materials are solid-dissolved into the indium oxide crystal by substitution, the indium oxide crystal comes to grow. When this indium oxide crystal grows in this case so that the grain size thereof exceeds about 10 µm, the generation of nodules increases.

Thus, in the sputtering target of the present embodiment, some parts of the gallium oxide and the germanium oxide, among the sintering starting materials, are solid-dissolved into the indium oxide crystal by substitution, so as to suppress the growth of the indium oxide crystal. The remaining gallium oxide and germanium oxide are present in crystal boundaries of the indium oxide, so as to suppress the growth of the indium oxide crystal still more. By the structure for attaining the suppression, the generation of nodules can be suppressed at the time of sputtering.

The [A1] component in this sputtering target is mainly made of indium oxide, and a part thereof is made of indium oxide wherein gallium atoms are solid-dissolved by substitution and indium oxide wherein germanium atoms are solid-dissolved by substitution. The indium oxide wherein the gallium atoms are solid-dissolved by substitution and the indium oxide wherein the germanium atoms are solid-dissolved by substitution can be identified, for example, by analysis based on EPMA (electron prove micro analysis).

The maximum grain size of the indium oxide crystal wherein the gallium atoms or the germanium atoms are solid-dissolved by substitution means an average value obtained as follows: in the case that the shape of the sputtering target is a circle, at the center (1 position) of the circle and intermediate positions (4 positions) between the center on two central lines which cross each other at the circle center and circular circumferences on the lines, that is, at 5 positions in all, or in the case that the sputtering target shape is a rectangle, at the center thereof (1 position) and intermediate positions (4 positions) between the center on the diagonal lines of the rectangle and corners thereof, that is, at 5 positions in all, about the maximum grain obtained by magnifying the polished surface of the target 2,500 times and observing a frame 50 µm square in the surface by means of a scanning electron microscope, the maximum size thereof is measured; and then the grain sizes of the maximum grains present in respective frames at the five positions are averaged.

It is preferable to use a size controlled into 5 µm or less as the maximum grain size of the indium oxide crystal present in this sputtering target, wherein the gallium atoms or the germanium atoms are solid-dissolved by substitution. This is because if the maximum grain size of the indium oxide crystal wherein the gallium atoms or the germanium atoms are solid-dissolved by substitution is more than 5 µm, indium oxide crystal wherein these metal atoms are not solid dissolved by substitution grows. That is, by setting the maximum grain size of the indium oxide crystal wherein the gallium atoms or the germanium atoms are solid-dissolved by substitution into 5 µm or less, the growth of the indium oxide crystal can be suppressed. The maximum grain size of the indium oxide crystal wherein the gallium atoms or the germanium atoms are solid-dissolved by substitution is more preferably 3 µm or less.

About the content by percentage of each of the components which constitute the sintered product used in the production of this sputtering target, the content by percentage of the [A1] component is set into 85 to 99% by mass, and the content by percentage of the total of the [B] component and the [C] component is set into 1 to 15% by mass. The reason why the content by percentage of the total of the [B] component and the [C] component is set into 1 to 15% by mass as described above is that if the content by percentage of the two components is less than 1% by mass, the rate of the gallium atoms and the germanium atoms solid-dissolved into the indium oxide crystal by substitution is small so that the growth of the indium oxide crystal cannot be sufficiently suppressed. Furthermore, if the content by percentage of the two components is more than 15% by mass, it is difficult to control the grain size of the indium oxide wherein the gallium atoms are solid-dissolved by substitution or the indium oxide crystal wherein the germanium atoms are solid-dissolved by substitution, and further the conductivity of the resultant transparent conductive film is lowered. About the content by percentage of each of the components which constitute this sintered product, the content by percentage of the [A1] component is more preferably set into 90 to 97% by mass, and the content by percentage of the total of the [B] component and the [C] component is more preferably set into 3 to 10% by mass.

About the contents by percentage of the [B] component and the [C] component, the content by percentage of the gallium oxide type component of the [B] component is preferably equal to or more than that of the germanium oxide type component of the [C] component because a transparent conductive film excellent in light transmissibility can be obtained. This content by percentage of the [B] component is preferably 1.5 times or more larger than that of the [C] component, more preferably 2 times or more larger than that of the [C] component.

Next, a profess for producing the sputtering target of the present invention is, for example, as follows: the sputtering target can be produced by granulating, by casting or by means of a spray drier, mixture powder obtained by pulverizing a mixture of indium oxide, gallium oxide and germanium oxide, or additional tin oxide; press-molding the granulated product; sintering the molded product; and then cutting the resultant sintered product. Herein, the mixing and pulverizing of the respective metal oxides as starting materials can be performed using a wet-mixing pulverizer such as a wet ball mill or a bead mill, ultrasonic waves, or the like. Herein, it is preferable that the starting material powder is pulverized in such a manner that the average particle size of the pulverized product will be 1 µm or less.

About conditions for firing the metal oxides, under the atmosphere of air or oxygen gas, the firing temperature is set into 1,300 to 1,700°C. preferably 1.450 to 1,600°C, and the firing time is set into 2 to 36 hours, preferably 4 to 24 hours. It is preferable to set the temperature-rising rate at the time of the firing into 2 to 10°C/minute. Furthermore, in order to produce a sputtering target from the resultant sintered product, it is advisable to cut this sintered product into a shape suitable for being fitted to a sputtering machine and attach a fitting jig to this.

The sputtering target having the above-mentioned structure is used to make it possible to a transparent conductive film on a substrate by sputtering. The substrate used herein is preferably a highly transparent substrate, and may be a glass substrate, or a film or sheet made of a transparent synthetic resin which has been used so far. As such a synthetic resin, there can be used polycarbonate resin, polymethyl methacrylate resin, polyester resin, polyether sulfone resin, polyarylate resin or like.

When a film is formed by this sputtering, the formation can be performed using various sputtering machines. In particular, a magnetron sputtering machine is preferably used. About conditions when this magnetron sputtering machine is used to form the film by sputtering, the power of plasma is varied dependently on the surface area of the used target or the film thickness of the transparent conductive film to be produced. Usually, the power of the plasma is set into the range of 0.3 to 4 W per cm² of the target surface area and the time for forming the film is set into 5 to 120 minutes, whereby the transparent conductive film having a desired film thickness can be obtained. This film thickness of the transparent conductive film, which is varied in accordance with the kind of the display device, is usually from 200 to 6,000 angstroms, preferably from 300 to 2,000 angstroms.

The thus-obtained transparent conductive film is a transparent conductive film comprising a sintered product of a metal oxide comprising 85 to 99% by mass of [A1] (a1) indium oxide, and 1 to 15% by mass of the total of [B] gallium oxide and [C] germanium oxide, wherein the sintered product comprises, as components of the indium oxide, indium oxide wherein gallium atoms are solid-dissolved by substitution and indium oxide wherein germanium atoms are solid-dissolved by substitution.

In this transparent conductive film, the content by percentage of the [A1] component is set into 85 to 99% by mass and the content by percentage of the total of the [B] component and the [C] component is set into 1 to 15% by mass; therefore, excellent transparency and conductivity are exhibited. Additionally, the transparent conductive film is excellent in etching property since the film is amorphous. If the content by percentage of the total of the [B] component and the [C] component is less than 1% by mass, the transparent conductive film becomes crystalline and the etching property thereof deteriorates. If the content by percentage of the total of the [B] component and the [C] component is more than 15% by mass, the conductivity of the transparent conductive film comes to be lowered. As this transparent conductive film, a film wherein the content by percentage of the [A1] component is from 90 to 97% by mass and the content by percentage of the total of the [B] component and the [C] component is from 3 to 10% by mass is preferable since the film has more excellent conductivity and etching property.

### [Example 1]

### (1) Production of a sputtering target

At a ratio of indium oxide powder to gallium oxide powder to germanium oxide powder, as starting materials, of 86 parts by mass to 10 parts by mass to 4 parts by mass, the metal oxides were supplied into a wet ball mill, and they were mixed and pulverized for 10 hours to yield raw material powder having an average particle size of 1.8 to 2 µm. Next, the resultant raw material was dried and granulated with a spray drier, and the resultant particles were filled into a mold and molded under pressure by means of a pressing machine to yield a disc-form molded product having a diameter of 10 cm and a thickness of 5 mm.

Next, this molded product was put into a firing furnace and then sintered under the atmosphere of pressured oxygen gas for 6 hours while the sintering temperature was controlled into 1420 to 1480°C.

About the thus-obtained sintered product, the composition thereof was analyzed. As a result, the content by percentage of the [A1] component was 86% by mass, the content by percentage of the [B] component was 10% by mass, and the content by percentage of the [C] component was 4% by mass. This sintered product was analyzed by EPMA. As a result, it was proved that indium oxide crystal wherein gallium atoms were solid-dissolved by substitution and indium oxide crystal wherein germanium atoms were solid-dissolved by substitution were present. Additionally, it was proved that gallium oxide wherein indium atoms were solid-dissolved by substitution and germanium oxide wherein indium atoms were solid-dissolved by substitution were present. At the center (1 position) of the disc-form sintered product and intermediate positions (4 positions) between the center on two central lines which crossed each other at the circle center and circular circumferences on the lines, that is, at 5 positions in all thereof, the sintered product was magnified 2,500 times and photographed with a scanning electron microscope. About the maximum crystal grain observed in a frame 50 µm square thereof, the maximum grain size thereof was measured. The average value of the maximum grain sizes of the maximum crystal grains present in frames at these 5 positions was calculated. As a result, it was 2.3 µm. The density of this sintered product was 6.65 g/cm³. This corresponded to 96% of the theoretical density ratio. Furthermore, the bulk resistance value of this sintered product, measured by a four-prove method, was 3.8 × 10⁻³ Ω·cm.

The thus-obtained sintered product was cut to produce a sputtering target having a diameter of about 10 cm and a thickness of about 5 mm.

### (2) Observation whether nodules were generated or not

The sputtering target obtained in the above-mentioned (1) was adhered to a plate made of copper, and the resultant was attached to a DC magnetron sputtering machine. As the atmosphere therein, a mixed gas wherein 3% hydrogen gas was added to argon gas was used to perform sputtering continuously for 30 hours. About conditions for the sputtering in this case, the pressure, the arrival pressure, the substrate temperature and the applying electric were set to 3 × 10⁻¹ Pa, 5 × 10⁻⁴ Pa, 25°C and 100 W, respectively. The hydrogen gas added to the atmospheric gas was for promoting the generation of nodules.

There was adopted a method of magnifying a change in the target surface after the sputtering 50 times and observing the change by means of a stereoscopic microscope, and calculating the number average of nodules 20 µm or more in size generated in a visual field 3 mm² in size. As a result, the generation of nodules in the surface of the sputtering target used herein was not observed.

The composition and physical properties of the sputtering target produced herein, and observation results as to whether nodules were generated or not are shown in Table 1.

### (3) Production of a transparent conductive film

The sputtering target obtained in the above-mentioned (1) was attached to a DC magnetron sputtering machine, and a transparent conductive film was formed on a glass substrate at room temperature. About conditions for the sputtering herein, a mixed gas wherein a small amount of oxygen gas was incorporated into argon gas was used as the atmosphere, and the sputtering pressure, the arrival pressure, the substrate temperature, the applying electric power and the time for forming the film were set to 3 × 10⁻¹ Pa, 5 × 10⁻⁴ Pa, 25°C, 100 W, and 20 minutes, respectively.

As a result, obtained was a transparent conductive glass wherein a transparent conductive film having a film thickness of about 2,000 angstroms was formed on a glass substrate.

### (4) Evaluation of the transparent conductive film

The transparent conductive film on the transparent conductive glass, which was obtained in the above-mentioned (3), was evaluated about the following items. The results are shown in Table 2.

### 1) Conductivity

About the conductivity, the specific resistance of the transparent conductive film was measured by a four-prove method. As a result, the value of the specific resistance was 480 × 10⁻⁶ Ω · cm.

### 2) Transparency

About the transparency, the light transmissibility was measured with a spectrometer. As a result, the light transmissibility was 78% about light having a wavelength of 400 nm. The light transmissibility was 91% about light having a wavelength of 550 nm.

### 3) Crystallinity

The crystallinity was measured by X-ray diffractometry. As a result, this transparent conductive film was amorphous.

### 4) Etching property

About the etching property, an aqueous oxalic acid solution having a concentration of 3.5% by mass was used as an etching solution, so as to carry out a test at 30°C. The state of an etched surface of the transparent conductive film after etching was observed with a stereoscopic micrometer. As a result, it was proved that no residue of the transparent conductive film was present on the etched surface of the film.

The same operation as described above was performed except that a mixed acid of nitric acid:phosphoric acid:acetic acid:water = 2:17:1800:1000 was used as the etching solution, so as to evaluate the etching property. As a result, it was proved that no residue of the transparent conductive film was present on the etched surface of the film.

### 5) Work function

The work function was measured by air ultraviolet ray electron spectrometry. As a result, the work function of this transparent conductive film was 4.4 electron volts.

### [Example 2]

### (1) Production of a sputtering target, and observation as to whether or not nodules were generated

A sputtering target was produced in the same way as in the (1) in Example 1 except that the ratio among used starting materials was set as follows: 91 parts by mass of indium oxide, 6 parts by mass of gallium oxide and 3 parts by mass of germanium oxide.

Next, in the same way as in the (2) in Example 1, it was observed whether or not nodules were generated at the time of sputtering about the resultant sputtering target.

The composition and physical properties of this sputtering target, and observation results as to whether or not the nodules were generated are shown in Table 1.

### (2) Production and evaluation of a transparent conductive film

A transparent conductive film was produced in the same way as in the (3) in Example 1 except that the sputtering target obtained in the above-mentioned (1) was used.

Next, about this transparent conductive film, the transparent conductive film was evaluated in the same way as in the (4) in Example 1. The evaluation results herein are shown in Table 2.

### [Example 3]

### (1) Production of a sputtering target, and observation as to whether or not nodules were generated

A sputtering target was produced in the same way as in the (1) in Example 1 except that the ratio among used starting materials was set as follows: 93 parts by mass of indium oxide, 4 parts by mass of gallium oxide and 3 parts by mass of germanium oxide.

Next, in the same way as in the (2) in Example 1, it was observed whether or not nodules were generated at the time of sputtering about the resultant sputtering target.

The composition and physical properties of this sputtering target, and observation results as to whether or not the nodules were generated are shown in Table 1.

### (2) Production and evaluation of a transparent conductive film

A transparent conductive film was produced in the same way as in the (3) in Example 1 except that the sputtering target obtained in the above-mentioned (1) was used.

Next, about the transparent conductive film obtained herein, the transparent conductive film was evaluated in the same way as in the (4) in Example 1. The evaluation results herein are shown in Table 2.

### [Example 4]

### (1) Production of a sputtering target, and observation as to whether or not nodules were generated

A sputtering target was produced in the same way as in the (1) in Example 1 except that the ratio among used starting materials was set as follows: 95 parts by mass of indium oxide, 3 parts by mass of gallium oxide and 2 parts by mass of germanium oxide.

Next, in the same way as in the (2) in Example 1, it was observed whether or not nodules were generated at the time of sputtering about the resultant sputtering target.

The composition and physical properties of this sputtering target, and observation results as to whether or not the nodules were generated are shown in Table 1.

### (2) Production and evaluation of a transparent conductive film

A transparent conductive film was produced in the same way as in the (3) in Example 1 except that the sputtering target obtained in the above-mentioned (1) was used.

Next, about the transparent conductive film obtained herein, the transparent conductive film was evaluated in the same way as in the (4) in Example 1. The evaluation results herein are shown in Table 2.

### [Comparative Example 1]

### (1) Production of a sputtering target, and observation as to whether or not nodules were generated

A sputtering target was produced in the same way as in the (1) in Example 1 except that only indium oxide powder was used as starting material.

Next, in the same way as in the (2) in Example 1, it was observed whether or not nodules were generated at the time of sputtering about the resultant sputtering target. After the sputtering was continuously performed for 30 hours, 45 nodules were observed in a visual field of size 3 mm², which was magnified 50 times, in the surface of this sputtering target.

The composition and physical properties of the sputtering target produced herein, and observation results as to whether or not the nodules were generated are shown in Table 1.

### (2) Production and evaluation of a transparent conductive film

A transparent conductive film was produced in the same way as in the (3) in Example 1 except that the sputtering target obtained in the above-mentioned (1) was used.

Next, about the transparent conductive film obtained herein, the transparent conductive film was evaluated in the same way as in the (4) in Example 1. The evaluation results herein are shown in Table 2.

### [Comparative Example 2]

### (1) Production of a sputtering target, and observation as to whether or not nodules were generated

A sputtering target was produced in the same way as in the (1) in Example 1 except that the ratio between used materials was set as follows: 94 parts by mass of indium oxide and 6 parts by mass of gallium oxide.

Next, in the same way as in the (2) in Example 1, it was observed whether or not nodules were generated at the time of sputtering about the resultant sputtering target. After the sputtering was continuously performed for 30 hours, 24 nodules were observed in a visual field of size 3 mm², which was magnified 50 times, in the surface of this sputtering target.

The composition and physical properties of the sputtering target produced herein, and observation results as to whether or not the nodules were generated are shown in Table 1.

### (2) Production and evaluation of a transparent conductive film

A transparent conductive film was produced in the same way as in the (3) in Example 1 except that the sputtering target obtained in the above-mentioned (1) was used.

Next, about the transparent conductive film obtained herein, the transparent conductive film was evaluated in the same way as in the (4) in Example 1. The evaluation results herein are shown in Table 2.

### [Comparative Example 3]

### (1) Production of a sputtering target, and observation as to whether or not nodules were generated

A sputtering target was produced in the same way as in the (1) in Example 1 except that the ratio between used materials was set as follows: 94 parts by mass of indium oxide and 6 parts by mass of germanium oxide.

Next, in the same way as in the (2) in Example 1, it was observed whether or not nodules were generated at the time of sputtering about the resultant sputtering target. After the sputtering was continuously performed for 30 hours, 21 nodules were observed in a visual field of size 3 mm², which was magnified 50 times, in the surface of this sputtering target.

The composition and physical properties of the sputtering target produced herein, and observation results as to whether or not the nodules were generated are shown in Table 1.

### (2) Production and evaluation of a transparent conductive film

A transparent conductive film was produced in the same way as in the (3) in Example 1 except that the sputtering target obtained in the above-mentioned (1) was used.

Next, about the transparent conductive film obtained herein, the transparent conductive film was evaluated in the same way as in the (4) in Example 1. The evaluation results herein are shown in Table 2.

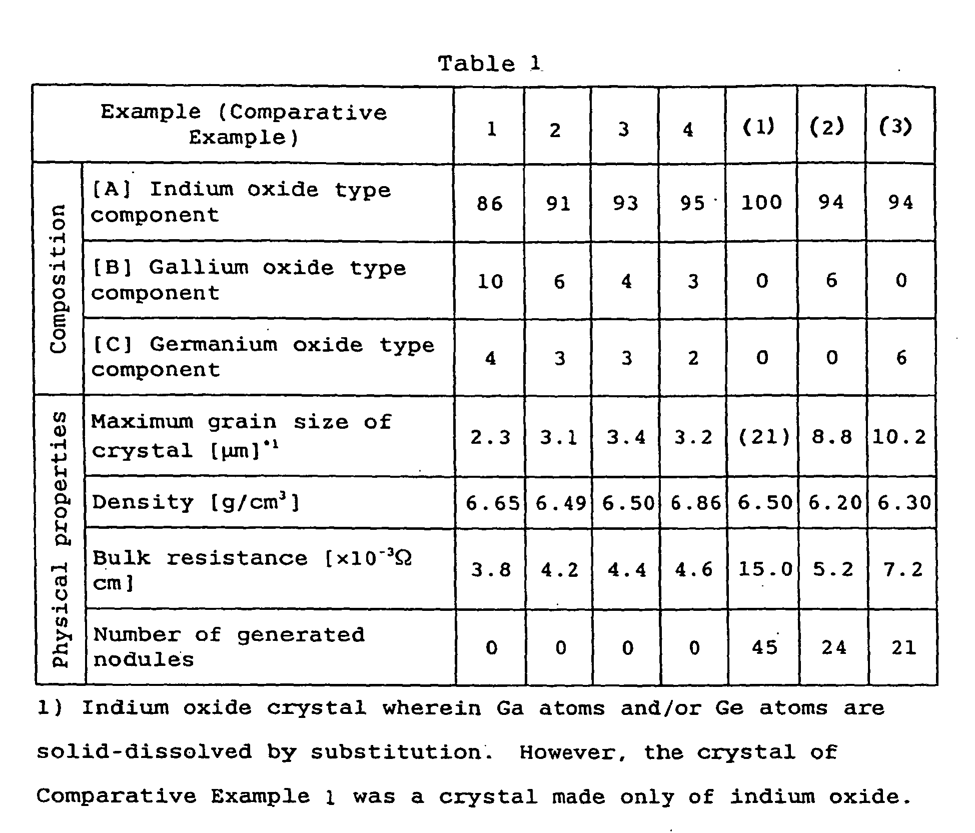

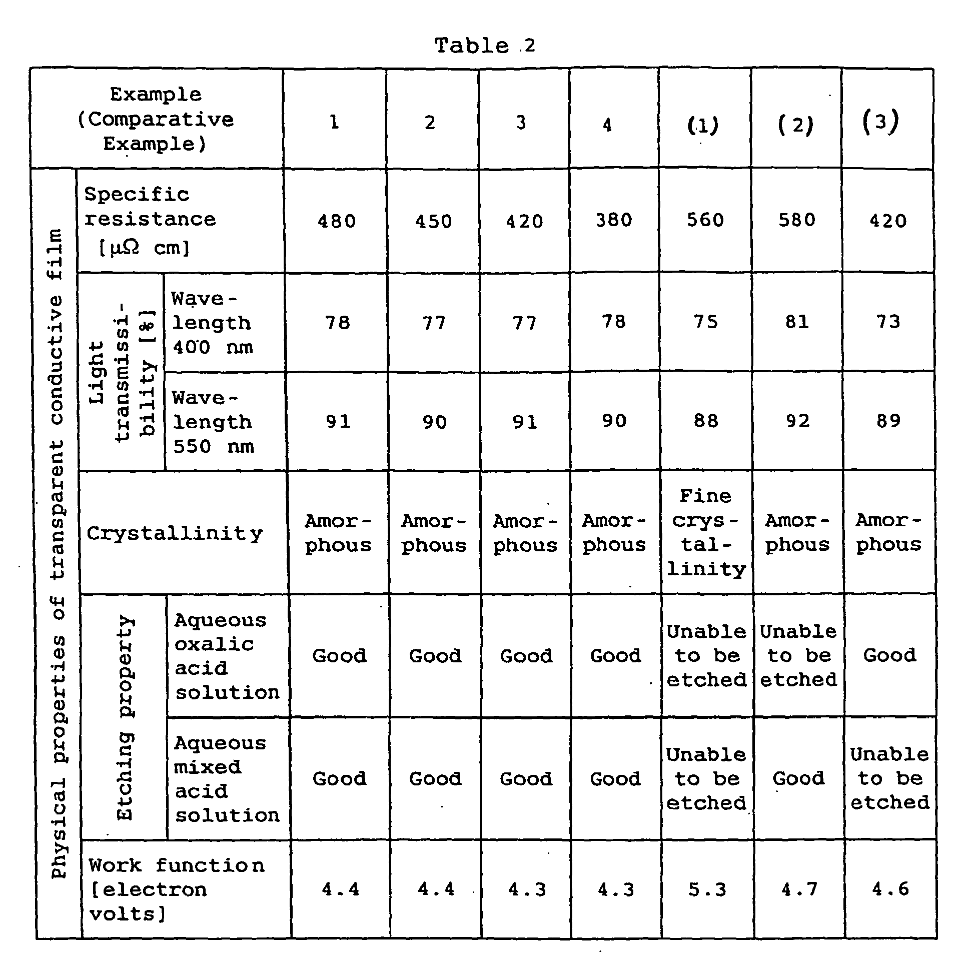

### Industrial Applicability

According to the sputtering target of the present invention, at the time of using this to form a transparent conductive film, the generation of nodules is suppressed and the formation of the film can be performed with stability and good productivity. Therefore, a transparent conductive film having a good quality can be produced with good productivity. Since the transparent conductive film can be etching-worked with a weak acid, an electrode can be worked without producing any adverse effect on wiring material for a thin film transistor or the like.

## Claims

1. A sputtering target, comprising a sintered product of a metal oxide that comprises (a1) indium oxide, [B] gallium oxide and [C] germanium oxide, the sintered product of a metal oxide comprising 85 to 99% by mass of [A1] (a1) indium oxide, and 1 to 15% by mass of the total of [B] gallium oxide and [C] germanium oxide, wherein the sintered product comprises, as components of the indium oxide, indium oxide wherein gallium atoms are solid- dissolved by substitution and indium oxide wherein germanium atoms are solid-dissolved by substitution.

2. The sputtering target according to claim 1, wherein the maximum grain size of each of crystal of the indium oxide wherein the gallium atoms are solid-dissolved by substitution and crystal of the indium oxide wherein the germanium atoms are solid-dissolved by substitution is 5 µm or less.

## Patentansprüche

1. Sputtering-Target, umfassend ein gesintertes Produkt aus einem Metalloxid, das umfasst (a1) Indiumoxid, [B] Galliumoxid und [C] Germaniumoxid, wobei das gesinterte Produkt aus einem Metalloxid 85 bis 99 Gew.-% [A1] (a1) Indiumoxid und 1 bis 15 Gew.-% der Gesamtheit von [B] Galliumoxid und [C] Germaniumoxid umfasst, wobei das gesinterte Produkt als Komponenten des Indiumoxids Indiumoxid, bei dem Galliumatome durch Substitution im Feststoff gelöst sind und Indiumoxid, bei dem Germaniumatome durch Substitution im Feststoff gelöst sind, umfasst.

2. Sputtering-Target nach Anspruch 1, wobei die maximale Korngröße jedes der Kristalle des Indiumoxids, bei dem Galliumatome durch substitution im Feststoff gelöst sind, und der Kristalle des Indiumoxids, bei dem Germaniumatome durch Substitution im Feststoff gelöst sind, 5 µm oder weniger beiträgt.

## Revendications

1. Cible de pulvérisation comprenant un produit fritté d'un oxyde d'un métal qui comprend un oxyde d'indium (a1), un oxyde de galium [B] et un oxyde de germanium [C], le produit fritté d'un oxyde d'un métal comprenant de 85 à 99 % en masse d'un oxyde d'indium [A1] (a1), et de 1 à 15 % en masse de la totalité d'un oxyde de galium [B] et d'un oxyde de germanium [C], dans lequel le produit fritté comprend comme composés de l'oxyde d'indium, l'oxyde d'indium dans lequel des atomes de galium sont dissous sous forme solide par substitution et l'oxyde d'indium dans lequel des atomes de germanium sont dissous sous forme par substitution.

2. Cible de pulvérisation selon la revendication 1, dans lequel la taille de grain maximum du chaque cristal de l'oxyde d'indium dans lequel des atomes de galium sont dissous sous forme solide par substitution et du cristal de l'oxyde d'indium dans lequel des atomes de germanium sont dissous sous forme solide par substitution est 5 µm ou moins.
